# EUROPEAN PATENT APPLICATION

(11) **EP 4 601 445 A1**
(43) Date of publication of application: **13.08.2025**
(21) Application number: 23880179.9
(22) Date of filing: 17.10.2023
(51) Int. Cl.: H10K 71/00, H10K 71/50, H10K 77/10, H05K 1/09, H05K 3/34, H10K 59/123

(54) **RELAY BOARD**

(30) Priority: 18.10.2022 KR 20220133828; 30.11.2022 KR 20220164971
(71) Applicant: Samsung Electronics Co., Ltd., Suwon-si, Gyeonggi-do 16677 (KR)
(72) Inventor: SEO, Yeonghyeon, Suwon-si Gyeonggi-do 16677 (KR); KIM, Jinyoung, Suwon-si Gyeonggi-do 16677 (KR); LEE, Byunghoon, Suwon-si Gyeonggi-do 16677 (KR); KOO, Jamyeong, Suwon-si Gyeonggi-do 16677 (KR)
(74) Representative: HGF
(86) International application number: PCT/KR2023/016051
(87) International publication number: WO 2024/085602

(57) **Abstract**

According to an embodiment of the present disclosure, a relay board for manufacturing a display may comprise: a transparent plate; a transparent buffer material disposed under the plate; and a pattern layer disposed between the plate and the buffer material and including a plurality of patterned holes formed so as to face a plurality of pixel chips of the display.

## Description

### [Technical Field]

An embodiment of the disclosure relates to a relay board.

### [Background Art]

Thanks to the remarkable development of information and communication technology and semiconductor technology, the distribution and use of various electronic devices is rapidly increasing. In particular, recent electronic devices are being developed so that the electronic devices can be carried and used for communication.

In addition, electronic devices may output stored information as sound or video. As the degree of integration of electronic devices increases and high-speed and high-capacity wireless communication becomes more common, recently, a variety of functions may be installed in a single electronic device such as a mobile communication terminal. For example, in addition to a communication function, an entertainment function such as a game, a multimedia function such as a music/video playback, a communication and security function for mobile banking, a schedule management, and an electronic wallet function are integrated into one electronic device. Such an electronic device is being miniaturized so that a user can conveniently carry the electronic device. Recently, as the miniaturization, thinness, and portability of a portable electronic device such as a smartphone have been emphasized, research is continuously being conducted to make the appearance of the electronic device more beautiful in terms of design.

### [Detailed Description of the Invention]

### [Technical Solution]

According to an embodiment of the disclosure, a relay board configured to manufacture a display may include a transparent plate, a transparent buffer material disposed below the plate, and a pattern layer disposed between the plate and the buffer material and including a plurality of patterned holes formed to face a plurality of pixel chips of the display.

According to an embodiment of the disclosure, a method for manufacturing a display module of an electronic device may include a first process of preparing a lower substrate and a plurality of pixel chips, a second process of arranging the plurality of pixel chips on a relay board, a third process of aligning a plurality of patterned holes formed in the relay board to face the plurality of pixel chips of a display, a fourth process of temporarily fixing, on the lower substrate, the relay board and the plurality of pixel chips aligned on the relay board, and a fifth process of soldering the plurality of pixel chips to the lower substrate using a laser.

### [Brief Description of Drawings]

FIG. 1 is a block diagram of an electronic device in a network environment, according to an embodiment disclosed herein.
FIG. 2 is a perspective view showing a front surface of an electronic device, according to an embodiment disclosed herein.
FIG. 3 is a perspective view showing a rear surface of the electronic device illustrated in FIG. 2, according to an embodiment disclosed herein.
FIG. 4A is an exploded perspective view showing the front surface of the electronic device illustrated in FIG. 2 according to an embodiment disclosed herein.
FIG. 4B is an exploded perspective view showing the rear surface of the electronic device illustrated in FIG. 2 according to an embodiment disclosed herein.
FIGS. 5A and 5B are cross-sectional views schematically showing a display module in an electronic device according to an embodiment disclosed herein.
FIG. 6 is a cross-sectional view showing a process for manufacturing a display module using a relay board in an electronic device according to an embodiment disclosed herein.
FIGS. 7A, 7B, and 7C are diagrams showing a pattern layer of a relay board according to an embodiment disclosed herein.

### [Mode for Carrying out the Invention]

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

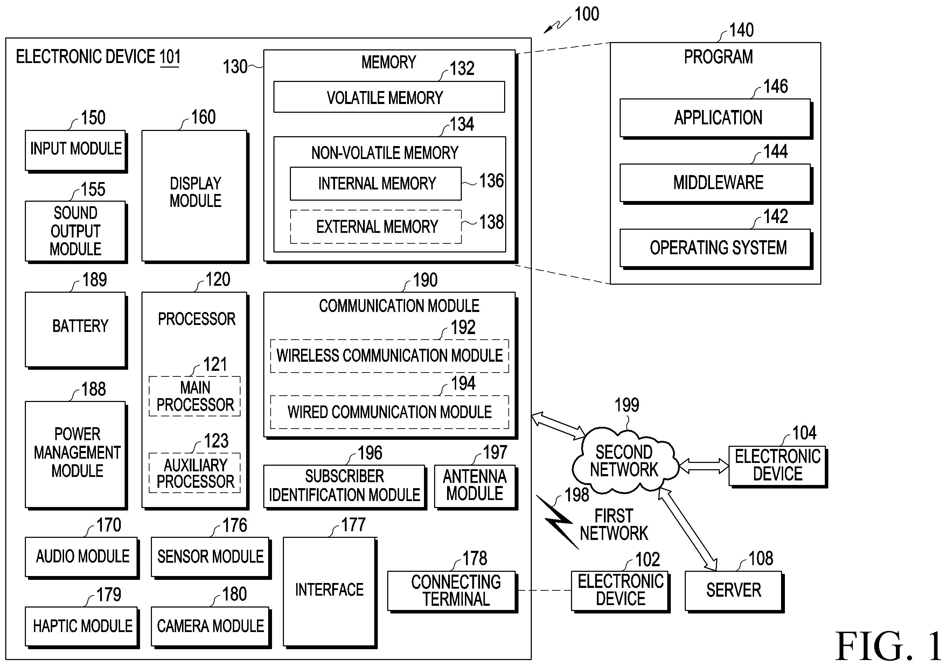

FIG. 1 is a block diagram illustrating an electronic device in a network environment according to an embodiment of the disclosure.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

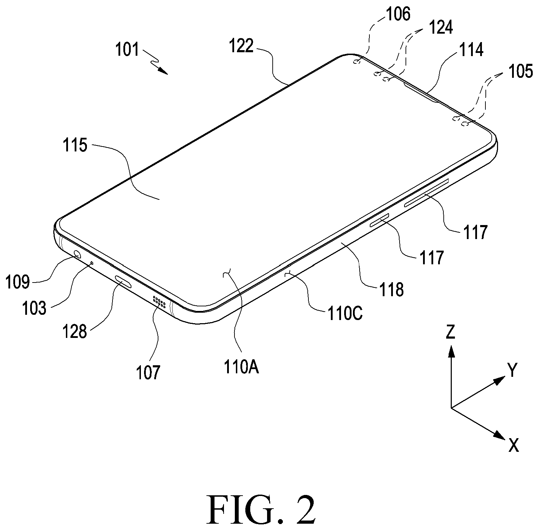

FIG. 2 is a perspective view showing a front surface of an electronic device 101, according to an embodiment disclosed herein.

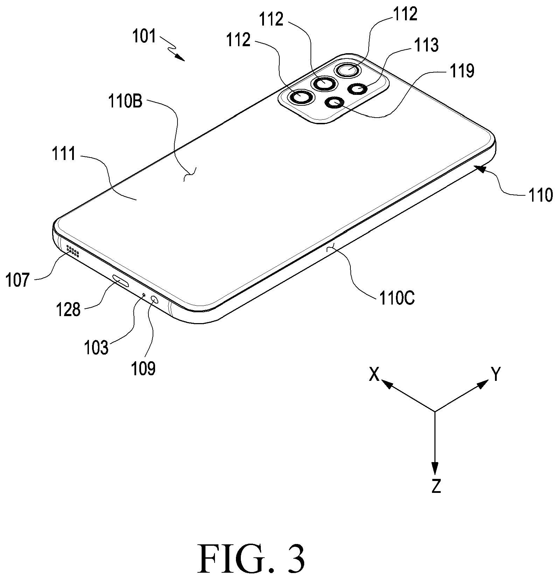

FIG. 3 is a perspective view showing a rear surface of the electronic device 101 illustrated in FIG. 3, according to an embodiment disclosed herein.

Referring to FIGS. 2 and 3, an electronic device 101 (e.g., the electronic device 101 of FIG. 1) according to an embodiment may include a housing 110 including a first surface (or a front surface) 110A, a second surface (or a rear surface) 110B, and a side surface 110C surrounding a space between the first surface 110A and the second surface 110B. In an embodiment (not shown), the housing 110 may refer to a structure which forms a portion of the first surface 110A of FIG. 2, the second surface 110B and the side surface 110C of FIG. 3.

According to an embodiment, the first surface 110A may be formed at least partially by a substantially transparent front plate 122 (e.g., a polymer plate or a glass plate including various coating layers). The second surface 110B may be formed by a substantially opaque rear plate 111. The rear plate 111 may be formed, for example, by coated or colored glass, ceramic, polymer, metal (e.g., aluminum, stainless steel (STS), or magnesium), or a combination of at least two of the foregoing materials. The side surface 110C may be formed by a side structure (or "a side bezel structure") 118 coupled with the front plate 122 and the rear plate 111 and including metal and/or polymer. In an embodiment, the rear plate 111 and the side structure 118 may be integrally formed and may include the same material (e.g., metal material such as aluminum).

According to an embodiment, the front plate 122 may include an area(s) that is bent from at least a portion of the edge thereof toward the rear plate 111 and extends seamlessly. For example, the front plate 122 (or the rear plate 111) may include only one of the areas bent and extending toward the rear plate 111 (or the front plate 122) at one edge of the first surface 110A. According to an embodiment, the front plate 122 or the rear plate 111 may have a substantially flat shape, and in such a case, the bent and extending area may not be included. In a case where the front plate 122 or the rear plate 111 is bent and includes an extended area, the thickness of the electronic device 101 at a portion including the bent and extending area may be smaller than the thickness of the electronic device at the other portions.

According to an embodiment, the electronic device 101 may include at least one of a display 115, an audio module (e.g., a microphone hole 103, an external speaker hole 107, a phone call receiver hole 114), a sensor module (e.g., a first sensor module 124, a second sensor module (not shown), and a third sensor module 119), a camera module (e.g., a first camera device 105, a second camera device 112, and a flash 113), key input devices 117, a light-emitting element 106, and connector holes (e.g., a first connector hole 128 and a second connector hole 109). In an embodiment, the electronic device 101 may omit at least one of the components (e.g., the key input devices 117 or the light-emitting element 106) or may additionally include other components.

For example, the display 115 may output a screen or be visually exposed through a considerable portion of the first surface 110A (e.g., the front plate 122). In an embodiment, at least a portion of the display 115 may be visually exposed through the front plate 122 forming the first surface 110A or through a portion of the side surface 110C. In an embodiment, the edges of the display 115 may be formed to be substantially the same as the adjacent outer shape of the front plate 122. In an embodiment (not shown), in order to expand the area in which the display 115 is visually exposed, the distance between the outer edge of the display 115 and the outer edge of the front plate 122 may be formed to be substantially uniform.

According to an embodiment, the display 115 may have a recess or an opening formed at a portion of a screen display area thereof, and may include at least one of an audio module (e.g., the phone call receiver hole 114), a sensor module (e.g., the first sensor module 124), a camera module (e.g., the first camera device 105), and the light-emitting elements 106 aligned with the recess or the opening. In an embodiment (not shown), the display 115 may include at least one of an audio module (e.g., the phone call receiver hole 114), a sensor module (e.g., the first sensor module 124), a camera module (e.g., the first camera device 105), and a fingerprint sensor (not shown), and the light-emitting element 106 on the rear surface of the screen display area. In an embodiment (not shown), the display 115 may be coupled with or disposed adjacent to a touch detection circuit, a pressure sensor capable of measuring the strength (pressure) of touch, and/or a digitizer configured to detect a magnetic field-type stylus pen.

According to an embodiment, the audio module 103, 107, and 114 may include a microphone hole 103 and a speaker hole (e.g., the external speaker hole 107 and the phone call receiver hole 114). A microphone configured to acquire external sound may be disposed inside the microphone hole 103, and in an embodiment, a plurality of microphones may be arranged inside the microphone hole to detect the direction of sound. The speaker hole may include the external speaker hole 107 and the phone call receiver hole 114. In an embodiment, the speaker hole (e.g., the external speaker hole 107 and the phone call receiver hole 114) and the microphone hole 103 may be implemented as one hole, or a speaker may be included without a speaker hole (e.g., the external speaker hole 107 and the phone call receiver hole 114) (e.g., a piezo speaker).

According to an embodiment, a sensor module may generate an electrical signal or data value corresponding to the internal operating state of the electronic device 101 or the external environmental state. The sensor module may include, for example, a first sensor module 124 (e.g., a proximity sensor) and/or a second sensor module (not shown) (e.g., a fingerprint sensor) disposed on the first surface 110A of the housing 110, and/or a third sensor module 119 disposed on the second surface 110B of the housing 110. The second sensor module (not shown) (e.g., a fingerprint sensor) may be disposed on the second surface 110B or the side surface 110C of the housing 110, as well as on the first surface 110A (e.g., the display 115). The electronic device 101 may further include, for example, at least one of a gesture sensor, a gyro sensor, a barometric pressure sensor, a magnetic sensor, an acceleration sensor, a grip sensor, a color sensor, an infrared (IR) sensor, a biometric sensor, a temperature sensor, a humidity sensor, or an illumination sensor 124.

According to an embodiment, a camera module may include a first camera device 105 disposed on the first surface 110A of the electronic device 101, a second camera device 112 disposed on the second surface 110B, and/or a flash 113. The camera devices (e.g., the first camera device 105, the second camera device 112) may include one or more lenses, an image sensor, and/or an image signal processor. The flash 113 may include, for example, a light emitting diode or a xenon lamp. In an embodiment, one or more lenses (an infrared camera, wide-angle and telephoto lenses) and image sensors may be arranged on one surface of the electronic device 101. In an embodiment, the flash 113 may emit infrared rays, and the infrared rays emitted by the flash 113 and reflected by a subject may be received through the third sensor module 119. The electronic device 101 or a processor of the electronic device 101 (e.g., the processor 120 of FIG. 1) may detect depth information of the subject based on the timepoint when infrared rays are received by the third sensor module 119.

According to an embodiment, the key input devices 117 may be arranged on the side surface 110C of the housing 110. In an embodiment, the electronic device 101 may not include some or all of the key input devices 117 mentioned above, and the key input devices 117 that are not included may be implemented in another form such as a soft key on the display 115. In an embodiment, the key input devices may include a sensor module disposed on the second surface 110B of the housing 110.

According to an embodiment, the light-emitting element 106 may be disposed, for example, on the first surface 110A of the housing 110. For example, the light-emitting element 106 may provide status information of the electronic device 101 in the form of light. In an embodiment, the light-emitting element 106 may provide, for example, a light source linked to the operation of a camera module (e.g., the first camera device 105). The light-emitting element 106 may include, for example, an LED, an IR LED, and a xenon lamp.

According to an embodiment, connector holes (e.g., the first connector hole 128, the second connector hole 109) may include a first connector hole 128, which can accommodate a connector (e.g. a USB connector) configured to transmit and receive power and/or data with an external electronic device (e.g., the electronic device 1002 of FIG. 1) and/or a second connector hole (e.g., an earphone jack) 109 capable of accommodating a connector configured to transmit and receive audio signals with an external electronic device.

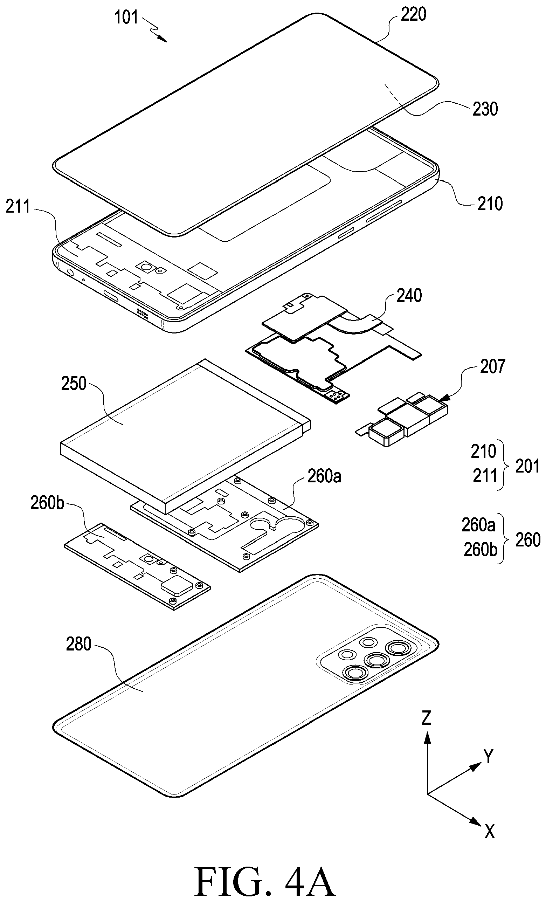

FIG. 4A is an exploded perspective view showing the front surface of the electronic device 101 illustrated in FIG. 2 according to an embodiment disclosed herein.

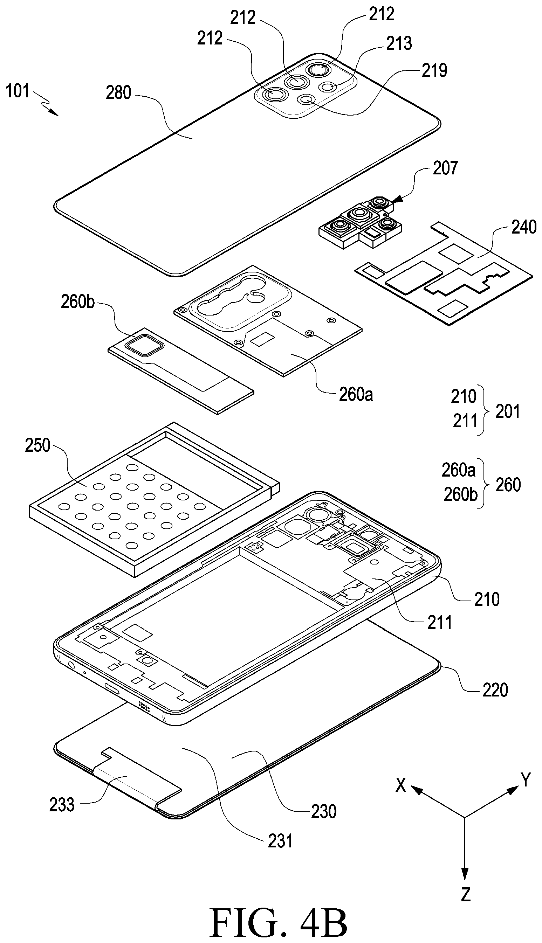

FIG. 4B is an exploded perspective view showing the rear surface of the electronic device 101 illustrated in FIG. 2 according to an embodiment disclosed herein.

Referring to FIGS. 4A and 4B, the electronic device 101 includes a side structure 210, a first support member 211 (e.g., a bracket), a front plate 220 (e.g., the front plate 122 in FIG. 2), and a display 230 (e.g., the display 115 in FIGS. 2 and 3), a printed circuit board (or a board assembly) 240, a battery 250, a second support member 260 (e.g., a rear case), an antenna, a camera assembly 207, and a rear plate 280 (e.g., the rear plate 111 in FIG. 3).

According to an embodiment, the electronic device 101 may omit at least one of the components (e.g., the first support member 211 or the second support member 260) or may additionally include other components. At least one of the components of the electronic device 101 may be the same or similar to at least one of the components of the electronic device 101 of FIG. 2 or 3, and overlapping descriptions will be omitted below.

According to an embodiment, the first support member 211 may be disposed inside the electronic device 101 to be connected to the side structure 210, or may be formed integrally with the side structure 210. The first support member 211 may be formed of, for example, a metallic material and/or a non-metallic (e.g., polymer) material. When the first support member or the side structure 210 is at least partially formed of a metal material, a portion of the side structure 210 or the first support member 211 may function as an antenna. The first support member 211 may have one surface coupled with the display 230 and the other surface coupled with the printed circuit board 240. A processor (e.g., the processor 120 in FIG. 1), a memory (e.g., the memory 130 in FIG. 1), and/or an interface (e.g., the interface 177 in FIG. 1) may be embedded on the printed circuit board 240. The processor may include, for example, one or more of a central processing unit, an application processor, a graphics processing unit, an image signal processor, a sensor hub processor, or a communication processor.

According to an embodiment, the first support member 211 and the side structure 210 may be combined and referred to as a front case or a housing 201. According to an embodiment, the housing 201 may be generally considered as a structure for accommodating, protecting, or arranging the printed circuit board 240 or the battery 250. In an embodiment, the housing 201 may be considered to include a structure which can be visually or tactilely recognized by a user on the exterior of the electronic device 101, for example, a side structure 210, the front plate 220, and/or the rear plate 280. In an embodiment, "the front or rear surface of the housing 201" may refer to the first surface 110A of FIG. 2 or the second surface 110B of FIG. 3. In an embodiment, the first support member 211 may be disposed between the front plate 220 (e.g., the first surface 110A in FIG. 2) and the rear plate 280 (e.g., the second surface 110B in FIG. 3), and may function as a structure configured to arrange electrical/electronic components such as the printed circuit board 240 or the camera assembly 207.

According to an embodiment, the display 230 may include a display panel 231 and a flexible printed circuit board 233 extending from the display panel 231. For example, the flexible printed circuit board 233 may be considered to be at least partially disposed on the rear surface of the display panel 231 and electrically connected to the display panel 231. In an embodiment, reference number "231" may be considered as indicating a protection sheet disposed on the rear surface of the display panel. For example, unless otherwise specified in the detailed description below, the protection sheet may be considered to be a part of the display panel 231. In an embodiment, the protection sheet may function as a buffering structure (e.g., a low-density elastomer such as a sponge) or an electromagnetic shielding structure (e.g., a copper sheet (CU sheet)) that absorbs external force. According to an embodiment, the display 230 may be disposed on the inner surface of the front plate 220, and may include a light-emitting layer to output a screen through the first surface 110A of FIG. 2 or at least a portion of the front plate 220. As mentioned earlier, the display 230 may output a screen substantially over the entire area of the first surface 110A or the front plate 220 of FIG. 2.

According to an embodiment, the memory may include, for example, a volatile memory or a non-volatile memory.

According to an embodiment, the interface may include, for example, a high definition multimedia interface (HDMI), a universal serial bus (USB) interface, an SD card interface, and/or an audio interface. For example, the interface may electrically or physically connect the electronic device 101 to an external electronic device and may include a USB connector, an SD card/MMC connector, or an audio connector.

According to an embodiment, the second support member 260 may include, for example, an upper support member 260a and a lower support member 260b. In an embodiment, the upper support member 260a may be disposed to surround the printed circuit board 240 along with a portion of the first support member 211. A circuit device (e.g., a processor, a communication module, or a memory) or various electrical/electronic components implemented in the form of integrated circuit chips may be arranged on the printed circuit board 240, and, according to an embodiment, the printed circuit board 240 may be provided with an electromagnetic shielding environment by the upper support member 260a. In an embodiment, the lower support member 260b may be utilized as a structure that can arrange electrical/electronic components such as a speaker module and an interface (e.g., a USB connector, an SD card/MMC connector, or an audio connector). In an embodiment, electrical/electronic components such as a speaker module and an interface (e.g., a USB connector, an SD card/MMC connector, or an audio connector) may be arranged on an additional printed circuit board (not shown). In this case, the lower support member 260b may be arranged together with the other portions of the first support member 211 to surround the additional printed circuit board. The speaker module or interface disposed on the lower support member 260b or the additional printed circuit board (not shown) may be disposed to correspond to the audio module (e.g., the microphone hole 103 or a speaker hole (e.g., the external speaker hole 107 and the phone call receiver hole 114)) or the connector holes (e.g., the first connector hole 128, the second connector hole 109) of FIG. 2.

According to an embodiment, the speaker module and interface may be disposed to correspond to the audio module 207 or the connector holes 128 and 109.

According to an embodiment, the battery 250 is a device configured to supply power to at least one component of the electronic device 101, and may include, for example, a non-rechargeable primary battery, a rechargeable secondary battery, or a fuel cell. For example, at least a portion of the battery 250 may be disposed on substantially the same plane as the printed circuit board 240. The battery 250 may be disposed integrally inside the electronic device 101, or may be disposed to be detachable from the electronic device 101.

Although not shown, an antenna may include, for example, a conductor pattern implemented on the surface of the second support member 260 through a laser direct structuring method. In an embodiment, the antenna may include a printed circuit pattern formed on the surface of a thin film, and the antenna in the form of a thin film may be disposed between the rear plate 280 and the battery 250. The antenna may include, for example, a near field communication (NFC) antenna, a wireless charging antenna, and/or a magnetic secure transmission (MST) antenna. For example, the antenna may perform short-distance communication with an external device or wirelessly transmit and receive power required for charging. In an embodiment, another antenna structure may be formed by a portion or a combination of the side structure 210 and/or the first support member 211.

According to an embodiment, the camera assembly 207 may include at least one camera module. Inside the electronic device 101, the camera assembly 207 may receive at least a portion of the light incident through an optical hole or camera windows 212, 213, 219. In an embodiment, the camera assembly 207 may be disposed on the first support member 211 at a location adjacent to the printed circuit board 240. In an embodiment, the camera module(s) of the camera assembly 207 may be generally aligned with any one of the camera windows 212, 213, 219, and may be at least partially surrounded by the second support member 260 (e.g., the upper support member 260a).

Hereinafter, the structure of the display 230 will be described in detail.

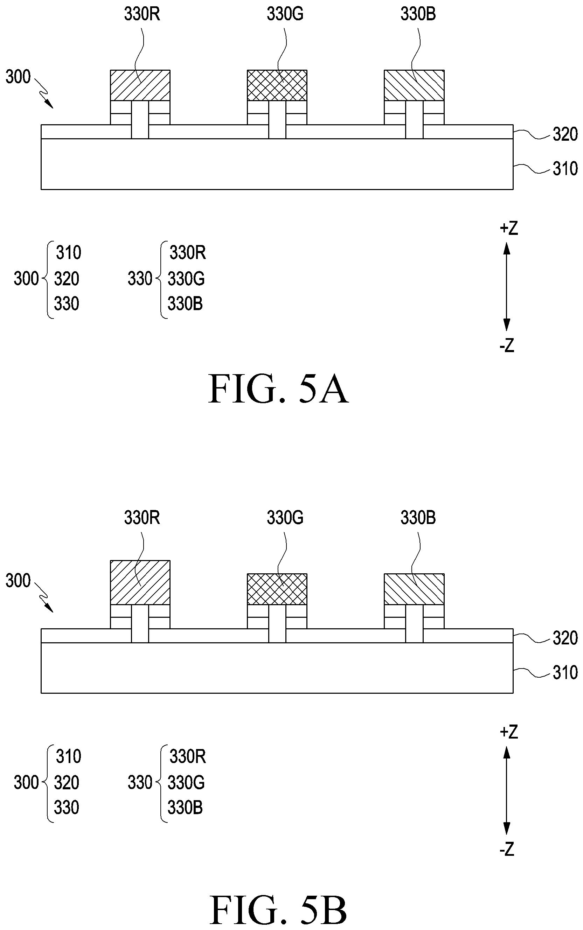

FIGS. 5A and 5B are cross-sectional views schematically showing a display module 300 in an electronic device (e.g., the electronic device 101) according to an embodiment disclosed herein.

Referring to FIGS. 5A and 5B, a display module 300 may include a substrate 310, a thin film transistor 320, and a plurality of pixel chips 330. The configuration of the display module 300 of FIGS. 5A and 5B may be partially or totally the same as the configuration of the display 230 of FIGS. 4A and 4B. The structures of FIGS. 5A and 5B may be selectively coupled with the structures of FIGS. 4A and 4B.

According to FIGS. 5A and 5B, a spatial coordinate system defined by the Z-axis is shown. Here, the Z-axis may represent the thickness direction of the electronic device 101.

According to an embodiment, the substrate 310 of the display module 300 may be any circuit board that can be electrically connected, such as a PCB, a PI, glass, or a flexible PCB.

According to an embodiment, the display module 300 may include an organic light emitting diodes (OLEDs) and a thin film transistor (TFT) 320 for controlling the OLEDs. The thin film transistor (TFT) 320 may include a switching transistor (switching TFT), a driving transistor (driving TFT), and a maintenance capacitor.

According to an embodiment, the thin film transistor (TFT) 320 may be omitted. The substrate 310 may be, for example, glass, a polyimide (PI) film, or a flexible substrate.

According to an embodiment, the display module 300 may include a plurality of pixel chips 330. In an embodiment disclosed herein, a pixel may be a single picture element and may be a minimum unit (unit pixel) constituting an image, but is not necessarily limited thereto.

According to an embodiment, the plurality of pixel chips 330 may include color pixels. A color pixel may be a single point, which is a minimum unit constituting an image. The plurality of pixel chips 330 may be configured to include a plurality of subpixels. For example, as shown in FIGS. 5A and 5B, the color pixel may include various color subpixels (e.g., a red light subpixel 330R, a green light subpixel 330G, a blue light subpixel 330B) provided to output various colors. The color subpixels (e.g., the red light subpixel 330R, the green light subpixel 330G, the blue light subpixel 330B) may be arranged substantially on the same plane to form a layer. The color subpixels (e.g., the red light subpixel 330R, the green light subpixel 330G, the blue light subpixel 330B) may be configured to absorb, reflect, or scatter a specific color (e.g., red, green, or blue).

According to an embodiment, when referring to FIG. 5B, the plurality of pixel chips 330 of the display module 300 may have different heights. For example, the height of the green light subpixel 330G may be intentionally formed higher than the height of the blue light subpixel 330B, or the height of the red light subpixel 330R may be formed relatively higher than the heights of the green light subpixel 330G and the blue light subpixel 330B (FIG. 5B).

According to an embodiment, the plurality of pixel chips 330 may have any suitable size and any suitable shape. For example, each pixel chip constituting the plurality of pixel chips 330 may have a width or height of approximately 25 µm, 50 µm, 100 µm, 200 µm, or 500 µm. For example, the plurality of pixel chips 330 constituting a uLED may have a height of approximately 10 µm. For example, the height deviation of the plurality of pixel chips 330 constituting the uLED may be approximately 1 µm or more and 10 µm or less. For example, the shape of the plurality of pixel chips 330 may be rectangular, square, or circular.

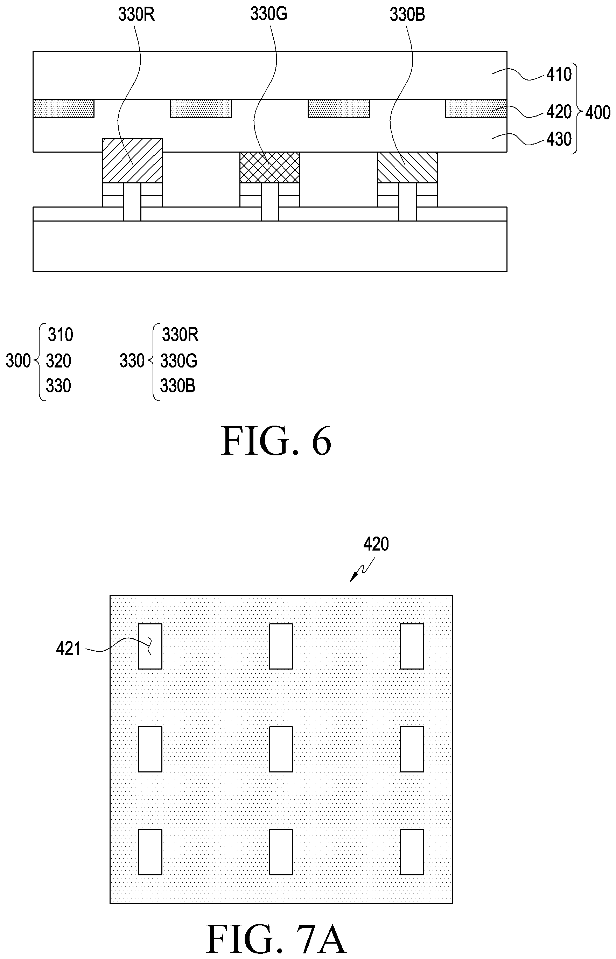

FIG. 6 is a cross-sectional view showing a process for manufacturing a display module 300 using a relay board 400 in an electronic device (e.g., the electronic device 101) according to an embodiment disclosed herein.

Referring to FIG. 6, the display module 300 may include a substrate 310, a thin film transistor 320, and a plurality of pixel chips 330. The configurations of the substrate 310, the thin film transistor 320, and the plurality of pixel chips 330 of the display module 300 of FIG. 6 may be partially or totally the same as the configurations of the substrate 310, the thin film transistor 320, and the plurality of pixel chips 330 of the display module 300 of FIGS. 5A and 5B. The structure of FIG. 6 may be selectively coupled with the structure of FIGS. 5A and 5B.

According to FIG. 6, a spatial coordinate system defined by the Z-axis is shown. Here, the Z-axis may represent the thickness direction of the electronic device 101.

According to an embodiment, a method for manufacturing the display module 300 may include a first process of preparing the substrate 310 and the plurality of pixel chips 330, a second process of arranging the plurality of pixel chips 330 on the relay board 400, a third process of aligning the plurality of patterned holes 421 formed in the relay board 400 to face the plurality of pixel chips 330 of the display module 300, a fourth process of temporarily fixing, on the substrate 310, the relay board 400 and the plurality of pixel chips 330 aligned on the relay board 400, and a fifth process of soldering the plurality of pixel chips 330 to the substrate 310 using a laser. This may relate to a method for fixing the plurality of pixel chips 330 to the thin film transistor 320 in a display manufacturing process.

According to an embodiment, when following the first process, in order to manufacture the display module 300, a substrate 310 may be provided and a thin film transistor (TFT) 320, and a plurality of pixel chips 330 may be provided on the substrate 310.

According to an embodiment, when following the second process, the plurality of pixel chips 330 may be arranged in a regular or repetitive pattern on the relay board 400. For example, the plurality of pixel chips 300 may be aligned at predetermined intervals in the horizontal direction (X axis direction) and the vertical direction (Y axis direction). However, among the plurality of pixel chips 330, the order and number of the red light subpixel 330R, the green light subpixel 330G, and the blue light subpixel 330B are not limited.

In order to fix the plurality of pixel chips 330 on the thin film transistor 320, the plurality of pixel chips 330 may be heated using a laser. However, when the entire substrate on which the thin film transistor 320 is mounted is heated, the laser may be emitted even to an area where there are no chips, and the substrate on which the thin film transistor 320 is mounted may be damaged. To prevent damage to the substrate on which the thin film transistor 320 is mounted, the relay board 400 including a pattern layer 420 serving as a mask may be used.

According to an embodiment, when following the third process and the fourth process, the relay (interposer) board 400 may be disposed and aligned on the plurality of pixel chips 330 and the relay board 400 may be temporarily fixed. The relay board 400 including the plurality of patterned holes 421 may be arranged so that a plurality of holes 421 faces the plurality of pixel chips 330 of the display module 300. According to an embodiment, after the plurality of chips 430 are transferred on the relay board 400 through various transfer techniques such as stamp, laser-lift-off (LLO), fluid self-assembly (FSA), and electrostatic micro-electro mechanical systems (MEMS), the relay board 400 may be aligned on the substrate on which the thin film transistor 320 is mounted. According to an embodiment, the fourth process may include at least one of UV curing, heat curing, a clamp method, and an adhesive method. The adhesive method may be a method using an adhesive, for example, at least one of adhesive tape or adhesive paste.

According to an embodiment, when following the fifth process, a laser may be emitted locally only to a portion where the plurality of chips 430 are located. The laser may be emitted locally only to a portion of the pattern layer 420 where the plurality of holes 421 are formed. The plurality of chips 430 may be soldered to a required area through laser irradiation. When soldering using a laser, the relay board 400 may be located on the substrate 310 including the thin film transistor 320, and may be pressed from the bottom to the top (+Z direction).

Hereinafter, the configuration and structure of the relay board 400, including the pattern layer 420 serving as a mask, will be described.

According to an embodiment, the relay board 400 may include a plate 410, a buffer material 430 disposed below the plate 410, and a pattern layer 420 disposed between the plate 410 and the buffer material 430.

According to an embodiment, the plate 410 may be formed to allow a laser to pass therethrough. The plate 410 may be formed of a transparent material to allow the laser to pass therethrough. The plate 410 may be any transparent substrate through which a laser can penetrate, such as quartz, sapphire, or EG-XG. The plate 410 may be, for example, any transparent substrate through which more than 90% of a laser can pass.

According to an embodiment, the plate 410 may be a wafer. The wafer may refer to a disk of a single crystal metal pillar thinly sliced to have an appropriate thickness. The wafer may include, for example, silicon (Si). The plate 410 may be, for example, a glass wafer. The glass wafer may be thinner and stronger than a silicon wafer.

According to an embodiment, the pattern layer 420 may be configured to limit a laser irradiation location so that only a desired location may be heated by the laser during laser irradiation. The pattern layer 420 may perform substantially the same role as a mask used in a fine metal mask (FMM) method which generally deposits an organic material at a desired location by attaching a mask to a substrate. The pattern layer 420 may serve as a reference point for aligning the plurality of chips 330 and the relay board 400.

According to an embodiment, the pattern layer 420 may be disposed below the plate 410 (e.g., in the -Z axis direction of FIG. 6). The pattern layer 420 may be disposed between the plate 410 and the buffer material 430. The relay board 400 may include the pattern layer 420, and thus additional flatness alignment may not be performed between the relay board 400 and the pattern layer 420 serving as a mask. Rather than disposing a mask on the relay board 400, the pattern layer 420 serving as a mask may be provided inside the relay board 400 so that the pattern layer is positioned close to the plurality of pixel chips 430. In this case, during laser irradiation, the diffraction phenomenon between the pattern layer 420 and the plurality of pixel chips 430 may be reduced.

According to an embodiment, the pattern layer 420 may include metal. For example, the pattern layer 420 may include chromium (Cr).

According to an embodiment, the pattern layer may include the plurality of patterned holes 421 formed to face the plurality of pixel chips 330 of the display module 300. According to an embodiment, when referring to FIG. 8, the location, number, and/or arrangement method of the plurality of holes 421 may correspond one to one to the location, number, and/or arrangement method of the plurality of pixel chips 330.

According to an embodiment, the buffer material 430 may be configured to directly contact the plurality of pixel chips 330 and pressurize the plurality of pixel chips 330. The buffer material 430 may serve as a cushion to reduce the height deviation of the plurality of pixel chips 330.

According to an embodiment, the buffer material 430 may be formed to allow a laser to pass therethrough. The buffer material 430 may be formed of a transparent material to allow the laser to pass therethrough. The buffer material 430 may be any transparent substrate made of a laser-transmissible material, such as quartz, sapphire, or EG-XG. The buffer material 430 may be, for example, any transparent substrate through which more than 90% of the laser can penetrate.

According to an embodiment, the buffer material 430 may be formed of a transparent polymer. For example, the buffer material 430 may include polydimethylsiloxane (PDMS, dimethylpolysiloxane). Polydimethylsiloxane (PDMS) is a widely used silicon-based polymer and may be referred to as "silicone". However, according to an embodiment, the buffer material 430 may be excluded from the configuration of the relay board 400.

According to an embodiment, the buffer material 430 may have a hardness of approximately 100 or less based on Shore hardness.

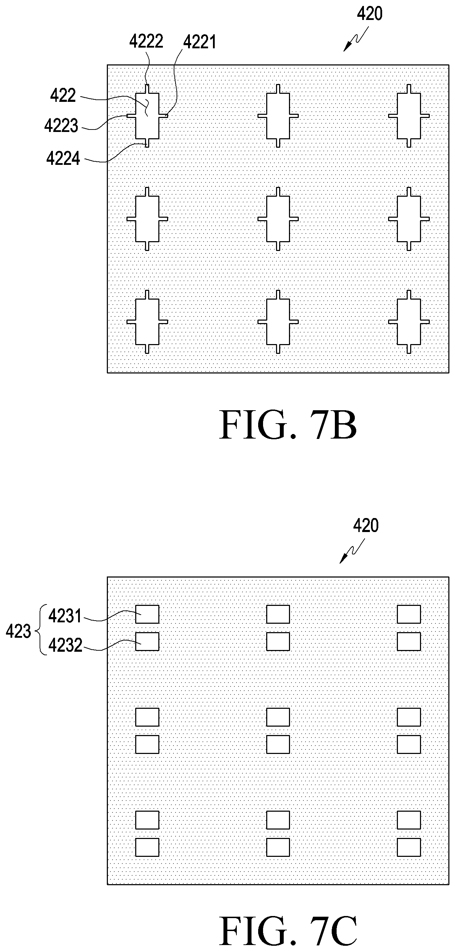

FIGS. 7A, 7B, and 7C are diagrams showing a pattern layer 420 of a relay board 400 according to an embodiment disclosed herein.

Referring to FIGS. 7A to 7C, the pattern layer 420 of the relay board 400 may include a plurality of holes 421. The configuration of the pattern layer 420 of FIGS. 7A to 7C may be partially or totally the same as the configuration of the pattern layer 420 of FIG. 6. The structures of FIGS. 7A to 7C may be selectively coupled with the structures of FIG. 6.

According to FIGS. 7A to 7C, a spatial coordinate system defined by the X axis and Y axis is shown. Here, the X-axis may represent the horizontal direction of an electronic device 101. The Y-axis may represent the vertical direction of the electronic device 101.

According to an embodiment, the pattern layer may include a plurality of patterned holes 421 formed to face the plurality of pixel chips 330 of the display module 300.

According to an embodiment, when referring to FIG. 7A, the location, number, and/or arrangement method of the plurality of holes 421 may correspond one to one to the location, number, and/or arrangement method of the plurality of pixel chips 330.

According to an embodiment, the shape of the plurality of holes 421 may correspond to the front shape of the plurality of pixel chips 330. For example, the shape of the plurality of holes may be rectangular, square, or circular. For example, in a case where the front shape of the plurality of pixel chips 330 is rectangular, the shape of the plurality of holes 421 may be rectangular.

According to an embodiment, the size of the plurality of holes 421 may be the same as or different from the size of the plurality of pixel chips 330. For example, depending on the bonding characteristics, the size of the plurality of holes may be smaller or larger than the size of the plurality of pixel chips 330.

According to an embodiment, when referring to FIG. 7B, the shape of a plurality of holes 422 may correspond to the front shape of a plurality of pixel chips (e.g., the plurality of pixel chips 330 in FIG. 6), and the plurality of holes may further include holes for position alignment to correspond to the positions of a plurality of pixel chips (e.g., the plurality of pixel chips 330 in FIG. 6). The holes for position alignment may have a cross shape, for example. The cross-formed holes may be in the form of a slit formed in the horizontal direction (e.g., X axis direction in FIG. 9) and/or in the vertical direction perpendicular thereto (e.g., Y axis direction in FIG. 9).

For example, when referring to FIG. 9, the shape of the plurality of holes 422 may further include thin slit-shaped holes 4221, 4222, 4223, and 4224 extending vertically from the center of each of the four sides of the rectangle.

According to an embodiment, when referring to FIG. 7C, the shape and location of a plurality of holes 423 may correspond to the shape and location of a plurality of metal pads arranged on the front surface of a plurality of pixel chips (e.g., the plurality of pixel chips 330 in FIG. 6). For example, each pixel chip constituting the plurality of pixel chips (e.g., the plurality of pixel chips 330 in FIG. 6) may include two metal pads on the front surface. The location and shape of each hole 4231 and 4232 constituting the plurality of holes 423 may correspond to the location and shape of the metal pad.

Display devices may be divided into a self-emissive display, in which each pixel emits light on its own, and a passive emissive display, which requires a separate light source.

A self-emissive display is provided with a light-emitting element for each pixel so that each pixel emits light on its own, and thus does not require a component such as a backlight unit, a liquid crystal layer, and a color filter. Accordingly, the self-emissive display may be structurally simple, may have a high degree of design freedom, and may be implemented with a thin thickness. In addition, the self-emissive display can achieve better contrast ratio, brightness, and viewing angle.

When heating each pixel using a laser as a method of soldering the pixel to a thin film transistor substrate, there is a need to heat only the area where the pixel is located. To this end, when a patterned mask is disposed on a relay board, it may be difficult to align the flatness between the relay board and the mask, and diffraction between the mask and the pixel may occur.

The disclosure relates to a method for manufacturing a display module 300 and a relay board 400 configured to reduce flatness errors and reduce the occurrence of diffraction phenomenon in pixels by using the relay board 400 including a pattern layer 420 serving as a mask.

The relay board 400 of the disclosure described above is not limited to the above-described embodiments and drawings, it will be obvious to a person skilled in the art that various substitutions, modifications, and changes are possible within the technical scope of the disclosure.

According to an embodiment of the disclosure, a relay board (400 in FIG. 6) for manufacturing a display module (300 in FIG. 6) may include a transparent plate (410 in FIG. 6), a transparent buffer material (430 in FIG. 6) disposed beneath the plate, and a pattern layer (420 in FIG. 6) disposed between the plate and the buffer material and including a plurality of patterned holes (421 in FIG. 7A) formed to face a plurality of pixel chips (330 in FIG. 6) of the display module.

According to an embodiment, the pattern layer may include metal.

According to an embodiment, the pattern layer may include chromium (Cr).

According to an embodiment, the plurality of holes may be formed to correspond one to one to the plurality of pixel chips.

According to an embodiment, the shape of the plurality of holes may be formed to correspond to the shape of the plurality of pixel chips.

According to an embodiment, the plurality of holes may have at least one of a rectangular shape, a square shape or a circular shape.

According to an embodiment, the shape of the plurality of holes may further include a cross shape.

According to an embodiment, the shape of the plurality of holes may be formed to correspond to the shape of a metal pad disposed on the plurality of pixel chips.

According to an embodiment, the plate may be formed to allow laser to pass therethrough.

According to an embodiment, the plate may be a glass wafer.

According to an embodiment, the buffer material may be formed to allow a laser to pass therethrough.

According to an embodiment, the buffer material may include polydimethylsiloxane (PDMS, dimethylpolysiloxane).

According to an embodiment of the disclosure, a method for manufacturing a display module (300 in FIG. 6) may include a first process of preparing a substrate and a plurality of pixel chips, a second process of arranging the plurality of pixel chips on a relay board, a third process of aligning a plurality of patterned holes formed in the relay board to face the plurality of pixel chips of a display, a fourth process of temporarily fixing, on the substrate, the relay board and the plurality of pixel chips aligned on the relay board, and a fifth process of soldering the plurality of pixel chips to the substrate using a laser.

According to an embodiment, the fourth process may include at least one of UV curing, heat curing, a clamp method, and an adhesive method.

According to an embodiment, the pattern layer may include metal.

According to an embodiment, the pattern layer may include chromium (Cr).

According to an embodiment, the plurality of holes may be formed to correspond one to one to the plurality of pixel chips.

According to an embodiment, the shape of the plurality of holes may be formed to correspond to the shape of the plurality of pixel chips.

According to an embodiment, the plurality of holes may have at least one of a rectangular shape, a square shape, and a circular shape.

According to an embodiment, the shape of the plurality of holes may further include a cross form.

## Claims

1. A relay board (400 in FIG. 6) for manufacturing a display module (300 in FIG. 6), the relay board comprising:
a transparent plate (410 in FIG. 6);
a transparent buffer material (430 in FIG. 6) disposed beneath the plate; and
a pattern layer (420 in FIG. 6) disposed between the plate and the buffer material and comprising a plurality of patterned holes (421 in FIG. 7A) formed to face a plurality of pixel chips (330 in FIG. 6) of the display module.

2. The relay board of claim 1, wherein the pattern layer comprises metal.

3. The relay board of one of claims 1 and 2, wherein the pattern layer comprises chromium (Cr).

4. The relay board of one of claims 1 to 3, wherein the plurality of holes is formed to correspond one to one to the plurality of pixel chips.

5. The relay board of one of claims 1 to 4, wherein the shape of the plurality of holes is formed to correspond to the shape of the plurality of pixel chips.

6. The relay board of one of claims 1 to 5, wherein the plurality of holes has at least one of a rectangular shape, a square shape or a circular shape.

7. The relay board of claim 6, wherein the shape of the plurality of holes further comprises a cross shape.

8. The relay board of one of claims 1 to 7, wherein the shape of the plurality of holes is formed to correspond to the shape of a metal pad disposed on the plurality of pixel chips.

9. The relay board of one of claims 1 to 8, wherein the plate is formed to allow a laser to pass therethrough.

10. The relay board of one of claims 1 to 9, wherein the plate is a glass wafer.

11. The relay board of one of claims 1 to 10, wherein the buffer material is formed to allow a laser to pass therethrough.

12. The relay board of one of claims 1 to 11, wherein the buffer material comprises polydimethylsiloxane (PDMS, dimethylpolysiloxane).

13. A method for manufacturing a display module of an electronic device, the method comprising:
a first process of preparing a substrate and a plurality of pixel chips;
a second process of arranging the plurality of pixel chips on a relay board;
a third process of aligning a plurality of patterned holes formed in the relay board to face the plurality of pixel chips of a display;
a fourth process of temporarily fixing, on the substrate, the relay board and the plurality of pixel chips aligned on the relay board; and
a fifth process of soldering the plurality of pixel chips to the substrate using a laser.

14. The method of claim 13, wherein the fourth process comprises at least one of UV curing, heat curing, a clamp method, and an adhesive method.

15. The method of one of claims 13 and 14, wherein the plurality of holes is formed to correspond one to one to the plurality of pixel chips.
